# EUROPÄISCHE PATENTSCHRIFT

(11) **EP 1 282 348 B1**
(45) Veröffentlichungstag und Bekanntmachung des Hinweises auf die Patenterteilung: **23.01.2013**
(21) Anmeldenummer: 02015947.1
(22) Anmeldetag: 17.07.2002
(51) Int. Cl.: H05K 7/14

(54) **Anschlusseinrichtung für die Hausleittechnik**
Connecting device for local networks
Dispositif de connexion pour réseaux locaux

(30) Priorität: 17.07.2001 DE 20111776 U
(43) Veröffentlichungstag der Anmeldung: 05.02.2003
(73) Patentinhaber: Zumtobel Lighting GmbH, 6850 Dornbirn (AT)
(72) Erfinder: Geiginger, Joachim, Dipl.-Ing., 6845 Hohenems (AT); Walter, Werner, Dr., 6850 Dornbirn (AT); Wohlgenannt, Rochus, Dipl.-Ing., 6850 Dorbirn (AT)
(74) Vertreter: Schmidt-Evers, Jürgen

(56) Entgegenhaltungen:
- DE-A- 4 019 465
- DE-A- 19 714 868
- DE-A- 19 959 476
- DE-C- 10 011 354
- DE-C- 19 605 698
- DE-U- 8 910 111

## Beschreibung

Die vorliegende Erfindung betrifft eine Anschlußeinrichtung für die Hausleittechnik nach dem Oberbegriff des Anspruches 1.

Moderne Systeme zur Steuerung von verschiedenen Geräten der Hausleittechnik weisen üblicherweise ein Stromversorgungs- und Busleitungsnetz auf, an das die einzelnen Geräte angeschlossen werden. Über die Busleitungen erfolgt ein Datentransfer zwischen einer zentralen Steuereinheit und den einzelnen Geräten, der zum Schalten, Steuern und Regeln der Geräte sowie zum Messen und Überwachen genutzt wird. Bei den verschiedenen Geräten kann es sich beispielsweise um elektrische Geräte, Melder oder Funktionsgeber handeln.

Zum Anschluß der Geräte sind Anschlußeinrichtungen vorgesehen, welche an verschiedenen Stellen des Gebäudes angeordnet und unmittelbar mit dem Bus- und Stromversorgungsnetz verbunden sind. Wesentliches Bestandteil einer solchen Anschlußeinrichtung ist eine - oftmals in einem sog. Master- oder Basismodul enthaltene - Busankopplungseinheit, die einen Mikroprozessor zur Datenübertragung enthält und für die Kommunikation mit der Zentrale des Hausleitsystems sowie den anderen Anschlußeinrichtungen zuständig ist. Darüber hinaus enthalten die Anschlußeinrichtungen funktionsspezifische Erweiterungsmodule, welche mit den elektrischen Geräten verbindbar sind und hierzu in einem Anschlußbereich dem jeweiligen Verbraucher entsprechende Anschlüsse aufweisen. Ein Erweiterungsmodul ist auf das anzuschließende Gerät abgestimmt und vermittelt der Anschlußeinrichtung dasjenige Verhalten, das für die Kommunikation bzw. Steuerung dieses Verbrauchers notwendig ist.

Anschlußeinrichtungen dieser Art sind beispielsweise aus der DE 40 19 465 A1 oder der DE 196 05 698 C1 bekannt. Sie bestehen aus einem an die Busleitung des Hausleitsystems angeschlossenen Mastermodul mit der Busankopplungseinheit sowie mehreren Erweiterungsmodulen, die seriell auf das Mastermodul aufgesteckt werden. Um eine Kommunikation der Erweiterungsmodule mit dem Mastermodul zu gewährleisten, sind bei der in der DE 40 19 465 A1 beschriebenen Anschlußeinrichtung mehrere Kommunikationsleitungen vorgesehen, die durch die Erweiterungsmodule hindurchgeführt sind und jeweils ein Erweiterungsmodul mit dem Mastermodul verbinden. Bei der Anschlußeinrichtung gemäß der DE 196 05 698 C1 hingegen ist eine einzelne aber ebenfalls durch alle Erweiterungsmodule hindurchgeführte Busleitung vorgesehen, die von allen Erweiterungsmodulen gemeinsam zur Kommunikation mit dem Mastermodul genutzt wird.

Diese beiden bekannten Anschlußeinrichtungen beanspruchen allerdings verhältnisnmäßig viel Raum und sind insbesondere für den Einbau oberhalb einer abgehängten Raumdecke oftmals nicht geeignet, da der zwischen der abgehängten Raumdecke und der tatsächlichen Decke des Raumes zur Verfügung stehende Freiraum manchmal nur wenig mehr als 5 cm hoch ist.

Eine weitere Schwierigkeit ergibt sich aus der seriellen Anordnung der verschiedenen Module. Soll beispielsweise ein bestimmtes Erweiterungsmodul ausgetauscht werden, so ist es notwendig, dieses zum Austausch vorgesehene Erweiterungsmodul gemeinsam mit den darauf aufgesteckten nachfolgenden Erweiterungsmodulen abzunehmen, die damit ebenfalls von dem Mastermodul getrennt werden. Dies hat zur Folge, daß die daran angeschlossenen Geräte vorübergehend nicht über das Hausleitsystem gesteuert werden können.

Aus der DE 197 14 868 A1 ist eine busfähige elektrische Koppeleinheit bekannt, die über Steuerleitungen mit vier Schützen verbunden ist, wobei jedes Schütz wiederum mit einem Motorschutzschalter verbunden ist. Die Magnetantriebe der Schütze sind als Aktoren vom Bussystem über die Koppeleinheit anzusteuern. Über Montageplatten lassen sich die Schütze und die Motorschutzschalter an einer Tragschiene aufschnappen und auch die Koppeleinheit kann auf der Tragschiene aufgeschnappt werden.

Aus der zwischenveröffentlichten DE 100 11 354 C1 ist ein elektrisches Gerät mit aneinandergereihten Modulen bekannt, die durch Brückenglieder zur Übertragung von elektrischen Signalen und Betriebsspaanung miteinander verbunden sind.

Der vorliegenden Erfindung liegt daher zunächst die Aufgabe zugrunde, eine Anschlußeinrichtung der eingangs genannten Art anzugeben, welche auch für den Einbau in sehr schmalen Freiräumen geeignet ist. Eine weitere Aufgabe der vorliegenden Erfindung besteht darin, eine flexible aber zuverlässige und sichere Verbindung der Erweiterungsmodule mit den Bus- und Stromleitungen sicherzustellen. Insbesondere soll ein Austausch einzelner Module möglich sein, ohne dabei die Funktionsfähigkeit der weiteren Module zu beeinträchtigen.

Diese Aufgaben werden durch die in dem unabhängigen Ansprüch angegebene Anschlußeinrichtung gelöst.

Gemäß Anspruch 1 ist eine Anschlußeinrichtung für die Hausleittechnik vorgesehen, welche eine an die Busleitungen des Hausleitsystems anschließbare Anschlußeinheit sowie ein oder mehrere funktionsspezifische Erweiterungsmodule aufweist, die mit der Anschlußeinheit verbindbar sind und Anschlüsse für den jeweiligen Verbraucher aufweisen. Erfindungsgemäß weist dabei die Anschlußeinheit eine flache längliche Form auf, wobei die Erweiterungsmodule im montierten Zustand an einer Längsseite der Anschlußeinheit parallel zu deren Flachseite angeordnet sind.

Durch diese erfindungsgemäße Lösung ergibt sich eine äußerst flache Struktur für die gesamte Anschlußeinrichtung, so daß diese auch für einen Einbau in sehr flachen Zwischenräumen geeignet ist.

Die Busankopplungseinheit gemäß Anspruch 1 ist in einem Mastermodul untergebracht, das in gleicher Weise wie die Erweiterungsmodule an der Anschlußeinheit angeordnet ist.

Weiterbildungen der Erfindung sind Gegenstand der Unteransprüche.

Vorzugsweise wird eine flexible aber zuverlässige Verbindung der Erweiterungsmodule mit der Anschlußeinheit dadurch sichergestellt, daß die Erweiterungsmodule lösbar mit der Anschlußeinheit verrastbar sind. Hierdurch sind die Erweiterungsmodule gegen ein unbeabsichtigtes Lösen von der Anschlußeinheit gesichert.

Vorzugsweise weisen die Erweiterungsmodule hierzu an ihren Rückseiten Rastvorsprünge auf, welche für den Eingriff in entsprechende Rastöffnungen der Anschlußeinheit vorgesehen sind. Zum Lösen der Verrastung kann insbesondere ein als Griffbügel ausgebildetes Betätigungselement vorgesehen sein, wobei dieser Griffbügel gleichzeitig auch als Haltegriff beim Abnehmen des Moduls dient. Hierdurch wird eine mit einem einfachen Handgriff zu bewerkstelligende Demontage der Module ermöglicht.

Vorzugsweise weist die Anschlußeinrichtung eine mit der Busleitung des Hausleitsystems verbundene Busankopplungseinheit sowie eine in einer Anschlußeinheit verlaufende und mit der Busankopplungseinheit verbundene interne Busleitung auf, an die die funktionsspezifischen Erweiterungsmodule anschließbar sind.

Im Unterschied zur der aus der DE 196 05 698 C1 bekannten Lösung verläuft somit die interne Busleitung nicht durch die Erweiterungsmodule sondern durch die Anschlußeinheit, so daß die Erweiterungsmodule unabhängig von den anderen Modulen angeschlossen oder entfernt werden können. Hierdurch wird ein flexibler Austausch der einzelnen Module ermöglicht.

Vorzugsweise kann die mit der Busleitung des Hausleitsystems verbundene Busankopplungseinheit im Sinne einer sternförmigen Verbindung jeweils über separate, durch die Anschlußeinheit verlaufende Datenleitungen mit den einzelnen Erweiterungsmodulen verbunden sein. Auch bei dieser Variante können die Erweiterungsmodule im Gegensatz zu bekannten Lösungen unabhängig von den anderen Modulen angeschlossen oder entfernt werden.

Im folgenden soll die Erfindung anhand der beiliegenden Zeichnung näher erläutert werden. Es zeigen:
- Fig. 1: ein Ausführungsbeispiel einer mit einem Mastermodul und vier Erweiterungsmodulen bestückten erfindungsgemäßen Anschlußeinrichtung;
- Fig. 2: die in Fig. 1 dargestellte Anschlußeinrichtung ohne Module;
- Fig. 3a: schematisch den Anschluß der verschiedenen Module an die Stromversorgung und an die Busankopplungseinheit über eine interne Busleitung;
- Fig. 3b: schematisch den Anschluß der verschiedenen Module an die Stromversorgung und an die Busankopplungseinheit in einer zweiten Variante,
- Fig. 4: die Vorderseite eines Erweiterungsmoduls; und
- Fig. 5: die Rück- und Unterseite des in Fig. 3 dargestellten Erweiterungsmoduls.

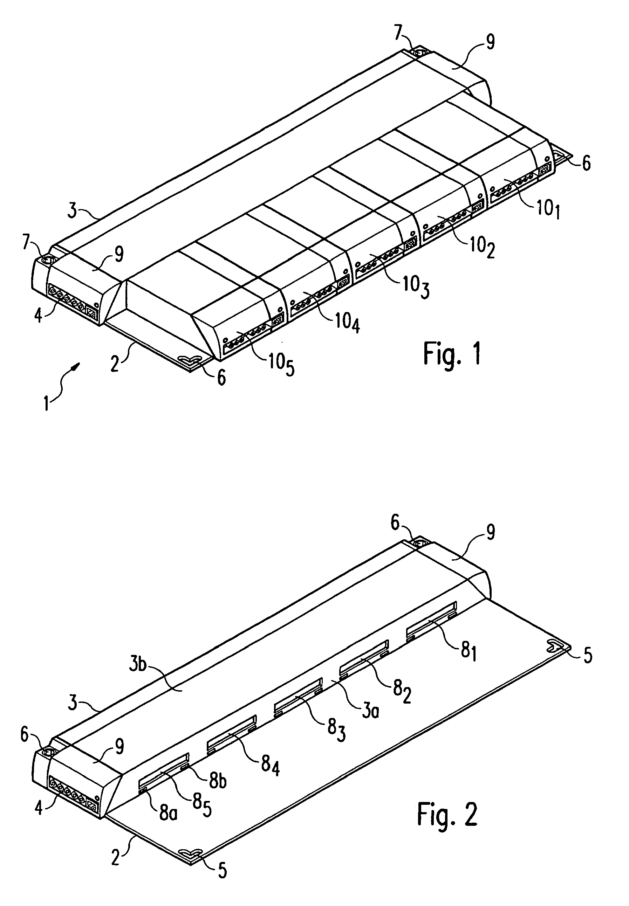

Die in den Fig. 1 und 2 dargestellte erfindungsgemäße Anschlußeinrichtung 1 besteht aus einer flachen länglichen Anschlußeinheit 3 sowie mehreren, seitlich an die Anschlußeinheit 3 anschließbaren Modulen 10₁ bis 10₅. Bei dem Modul 10₁ handelt es sich um ein sog. Mastermodul, welches eine Busankopplungseinheit enthält und für die Kommunikation mit der Zentrale des Hausleitsystems sowie den anderen Anschlußeinrichtungen zuständig ist. Das Mastermodul 10₁ enthält hierzu einen Mikroprozessor zur Datenübertragung. Die weiteren Module 10₂ bis 10₅ sind funktionsspezifische Erweiterungsmodule, welche mit den elektrischen Geräten des Hausleitsystems verbindbar sind und hierzu an ihren Stirnseiten entsprechende Anschlüsse aufweisen. Um ein zentrales Ansteuern der einzelnen an die Erweiterungsmodule 10₂ bis 10₅ angeschlossenen Geräte zu ermöglichen, sind die Erweiterungsmodule 10₂ bis 10₅ über eine interne Busleitung oder über separate Datenleitungen mit dem Mastermodul 10₁ verbunden, wie später noch ausführlich erläutert wird.

Im dargestellten Beispiel ist der Anschluß von bis zu fünf Modulen (einem Mastermodul und vier Erweiterungsmodulen) möglich, wobei diese Zahl in erster Linie von der Länge der Anschlußeinheit 3 abhängig ist. Denkbar wäre auch die Verwendung einer längeren oder kürzeren Anschlußeinheit 3, an die dann entsprechend mehr oder weniger Module angeschlossen werden können. Ferner ist im dargestellten Beispiel das Mastermodul 10₁ neben der Kommunikation mit der Zentrale zusätzlich auch zur Steuerung eines Verbrauchers vorgesehen und weist dementsprechend ebenfalls an seiner Stirnseite entsprechende Anschlüsse auf. Auch hier kann allerdings vorgesehen sein, das Mastermodul ausschließlich für den Datentransfer von der Zentrale zu den Erweiterungsmodulen bzw. in umgekehrter Richtung zu verwenden, wobei in diesem Fall an der Stirnseite des Mastermoduls keine weiteren Anschlüsse notwendig wären.

Die Anschlußeinheit 3 weist ein kastenförmiges längliches Gehäuse mit an den beiden Stirnseiten angeordneten Abschlußkappen 9 auf. Die beiden Abschlußkappen 9 sind für den Anschluß an die Stromversorgungsleitungen und Busleitungen des Hausleitsystems zuständig und besitzen hierzu entsprechende Anschlüsse 4 und 13 für die verschiedenen Phasen der Stromversorgung und die Datenleitung bzw. Datenleitungen.

An einer Längsseite 3a der Anschlußeinheit 3 sind fünf Steckplätze 8₁ bis 8₅ für das Mastermodul 10₁ und die Erweiterungsmodule 10₂ bis 10₅ vorgesehen. Bei der Montage wird ein Erweiterungsmodul 10₂ bis 10₅ automatisch an die innerhalb der Anschlußeinheit 3 verlaufenden Strom- und Bus- bzw. Datenleitungen angeschlossen, und zwar unabhängig davon, an welchen Steckplatz 8₂ bis 8₅ das Erweiterungsmodul 10₂ bis 10₅ angeschlossen wird und ob bereits ein oder mehrere Erweiterungsmodule 10₂ bis 10₅ angeschlossen wurden. Dies wird entweder durch eine innerhalb der Anschlußeinheit 3 verlaufende interne Busleitung oder durch mehrere interne Datenleitungen ermöglicht, wie später erläutert wird.

Die Bodenseite der Anschlußeinrichtung 3 ist über die die Steckplätze 8₁ bis 8₅ aufweisende Längsseite 3a hinaus durch eine Platte 2 verlängert. Diese Platte 2 dient gleichzeitig auch als Auflagefläche für die montierten Module 10₁ bis 10₅, wie insbesondere Fig. 1 zu entnehmen ist. Die Steckplätze 8₁ bis 8₅ sind dabei derart ausgebildet, daß die Module 10₁ bis 10₅ im montierten Zustand an der Längsseite 3a der Anschlußeinheit 3 und parallel zu deren Flachseite 3b angeordnet sind. Hierdurch ergibt sich die in Fig. 1 dargestellte sehr flache Form der gesamten Anschlußeinrichtung 1, so daß diese auch in sehr schmalen Zwischenräumen montiert werden kann.

Zur Befestigung sind an der Platte 2 sowie der Anschlußeinheit 3 vier Löcher 5 und 6 vorgesehen, mit deren Hilfe die gesamte Anschlußeinrichtung 1 an einer Decke oder Wand eines Raumes angeschraubt werden kann.

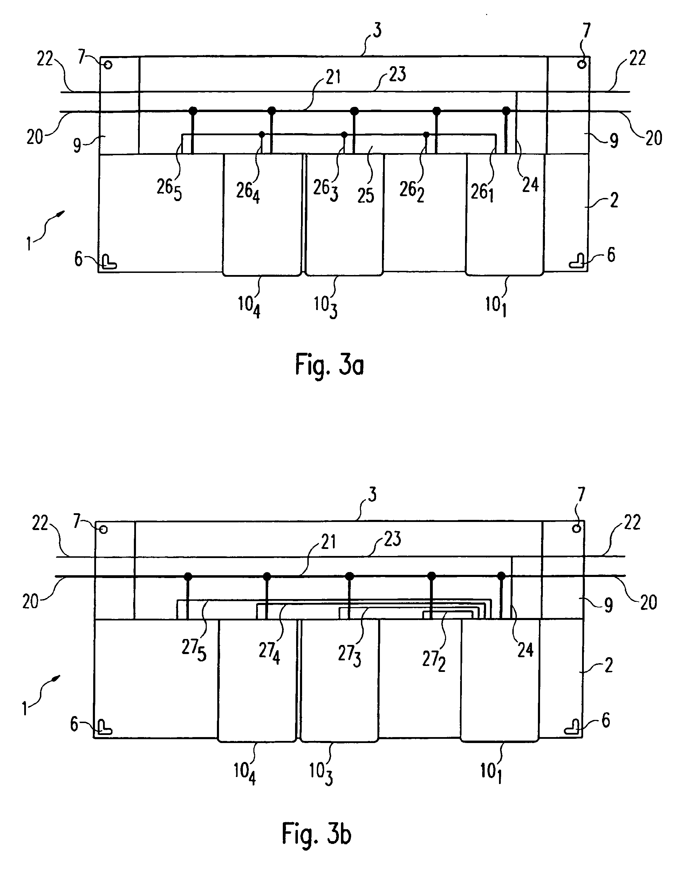

Eine erste Möglichkeit für die Verbindung der verschiedenen Module 10₁ bis 10₅ mit den Strom- und Busleitungen soll nunmehr mit Bezug auf die Fig. 3a erläutert werden, die schematisch den Verlauf der verschiedenen Leitungen innerhalb der erfindungsgemäßen Anschlußeinrichtung 1 zeigt. In dem hier dargestellten Beispiel sind das Mastermodul 10₁ an dem hierfür vorgesehenen rechten Steckplatz sowie zwei Erweiterungsmodule 10₃ und 10₄ an den mittleren Steckplätzen angeordnet, ferner sind aus Gründen der Übersichtlichkeit lediglich eine einzige Busleitung sowie eine einzige Stromleitung dargestellt.

Die Stromversorgung aller Module erfolgt durch eine innerhalb der Anschlußeinheit 3 verlaufende Stromleitung 21, welche an die externe Stromleitung 20 angeschlossen ist und zu den einzelnen Modul-Steckplätzen führende Abzweigungen aufweist. Zur Datenübertragung ist zunächst eine durch die Anschlußeinheit 3 verlaufende Leitung 23 vorgesehen, welche die externe Busleitung 22 des Hausleitsystems weiterführt.

Von der die externe Busleitung 22 weiterführenden Leitung 23 führt eine Abzweigung 24 zu dem rechten Modul-Steckplatz und somit zu dem Mastermodul 10₁, das mit seiner Busankopplungseinheit für die Kommunikation über die externe Busleitung 22 zuständig ist. Das Mastermodul 10₁ ist zusätzlich allerdings auch über eine Verbindungsleitung 26₁ mit einer internen Busleitung 25 verbunden, die sich durch die Anschlußeinheit 3 erstreckt und jeweils Verbindungsleitungen 26₂ bis 26₅ zu den Steckplätzen für die Erweiterungsmodule aufweist. Ein mit der Anschlußeinheit 3 verbundenes Erweiterungsmodul wird damit automatisch an die interne Busleitung 25 und über das Mastermodul 10₁ letztendlich an die externe Busleitung 22 des Hausleitsystems angeschlossen, und zwar unabhängig davon, ob die weiteren Steckplätze für die Erweiterungsmodule belegt sind oder nicht. Damit kann bei der erfindungsgemäßen Anschlußeinrichtung jedes Erweiterungsmodul für sich allein entfernt oder angeschlossen werden, ohne dabei die Funktionsfähigkeit der weiteren Module zu beeinträchtigen.

Eine zweite erfindungsgemäße Möglichkeit für die Verbindung der verschiedenen Module 10₁ bis 10₅ mit den Strom- und Busleitungen ist in Fig. 3b dargestellt. Anstelle der internen Busleitung sind hier mehrere Datenleitungen 27₂ bis 27₅ vorgesehen, die sich im Sinne einer sternförmigen Verbindung von dem Mastermodul 10₁ zu den Steckplätzen für die Erweiterungsmodule erstrecken. Damit wird jedes Erweiterungsmodul bei der Montage automatisch über eine separate Datenleitung 27₂ bis 27₅ mit dem Mastermodul 10₁ verbunden. Da sich auch bei dieser zweiten Variante die Datenleitungen 27₂ bis 27₅ durch die Anschlußeinheit 3 erstrecken, kann wiederum jedes Erweiterungsmodul für sich allein entfernt oder angeschlossen werden, ohne dabei die Funktionsfähigkeit der weiteren Module zu beeinträchtigen.

Anstelle der hier dargestellten Lösungen wäre es auch möglich, das Mastermodul 10₁ mit der Busankopplungseinheit in die Anschlußeinheit 3 zu integrieren. Wesentlich für das flexible Auswechseln der Erweiterungsmodule ist, daß die interne Busleitung 25 bzw. die Datenleitungen 27₂ bis 27₅ nicht durch die einzelnen Erweiterungsmodule sondern innerhalb der Anschlußeinheit 3 verlaufen, so daß die interne Busleitung 25 bzw. die Verbindung zwischen dem Mastermodul 10₁ und den verbleibenden Erweiterungsmodulen bei dem Entfernen eines Moduls nicht unterbrochen wird. Der Vorteil, die Busankopplungseinheit in Form einem auswechselbaren Steckmoduls unterzubringen, besteht darin, daß die für die Kommunikation verantwortliche Busankopplungseinheit auf einfache Weise ausgewechselt oder durch eine neuere Version ersetzt werden kann.

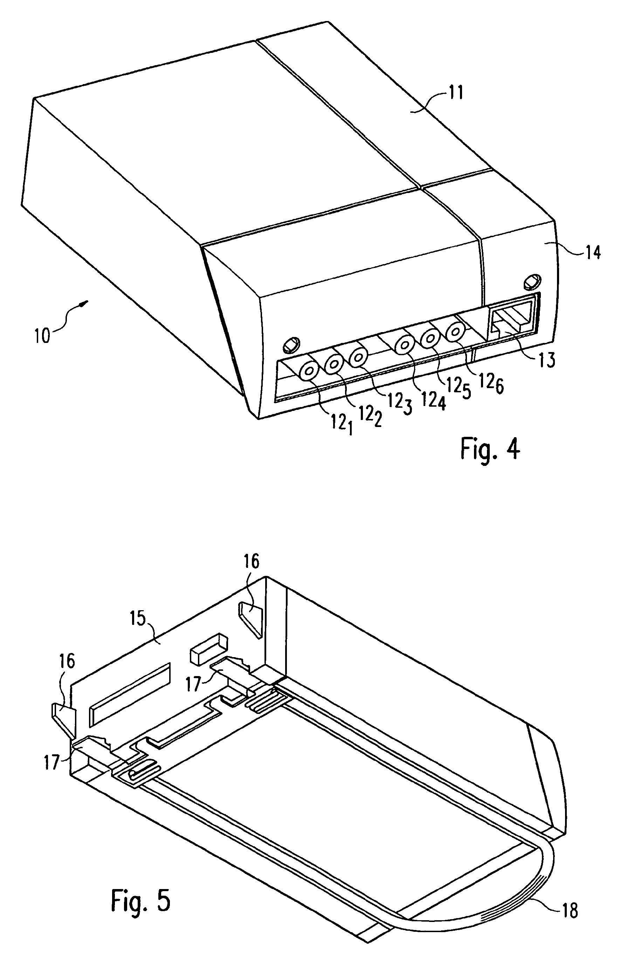

Eine vorteilhafte Ausgestaltung eines Erweiterungsmoduls 10 ist in den Fig. 4 und 5 dargestellt. Dieses Erweiterungsmodul 10 weist ein ebenfalls flaches Gehäuse 11 mit einer Stirnkappe 14 auf, welche für den jeweiligen Verbraucher entsprechende Anschlüsse 12₁ bis 12₆ und 13 aufweist. Insbesondere entspricht die Höhe des Erweiterungsmoduls 10 im wesentlichen der Höhe der Anschlußeinheit 3. Die Art und Anordnung der an der Frontkappe 14 vorgesehenen Anschlüsse kann dabei je nach Art des daran anzuschließenden elektrischen Verbrauchers variieren.

An der Rückseite 15 des Erweiterungsmoduls 10 sind entsprechende Anschlüsse vorgesehen, über die das Erweiterungsmodul 10 mit den innerhalb der Anschlußeinheit 3 verlaufenden Bus- und Stromleitungen verbunden werden kann. Um eine exakte Positionierung der Anschlüsse des Erweiterungsmoduls 10 bezüglich der Strom- und Busleitungen der Anschlußeinheit 3 zu ermöglichen, sind an der Rückseite 15 des Erweiterungsmoduls 10 zwei Führungsstifte 16 vorgesehen, welche eine Führung des Erweiterungsmoduls 10 bei der Montage gewährleisten. Darüber hinaus sind im unteren Bereich der Rückseite 15 zwei Rastvorsprünge 17 vorgesehen, welche bei der Montage in an der Längsseite 3a der Anschlußeinheit 3 vorgesehene - in Fig. 2 dargestellte - Rastöffnungen 8a eingreifen. Hierdurch sind die Erweiterungsmoduls 10 nach einer Montage vor einem unbeabsichtigten Lösen oder Herausfallen gesichert.

Ein Lösen eines Erweiterungsmoduls 10 wird durch einen - aus Gründen der Übersichtlichkeit - lediglich in Fig. 5 dargestellten Griffbügel 18 erreicht, der mit den beiden Rastvorsprüngen 17 derart zusammenwirkt, daß die Rastvorsprüngen 17 bei einem Zug an dem Bügel 18 leicht nach unten klappen und dementsprechend die Verrastung zwischen dem Erweiterungsmodul 10 und der Anschlußeinheit 3 gelöst wird. Der Bügel 18 dient dabei gleichzeitig auch als Griffbügel, so daß das Erweiterungsmodul 10 mit einem einzigen Handgriff von der Anschlußeinheit 3 gelöst und abgenommen werden kann.

Die mechanische Ausgestaltung des Mastermoduls ist identisch zu den Erweiterungsmodulen, so daß das Mastermodul in gleicher Weise wie die Erweiterungsmodule an die Anschlußeinheit 3 angeschlossen bzw. wieder entfernt werden kann.

Die erfindungsgemäße Anschlußeinrichtung zeichnet sich somit durch die besonders flache Gesamtkonstruktion sowie durch die Möglichkeit aus, die einzelnen Erweiterungsmodule auf einfache und sichere Weise an die Bus- und Stromleitungen anzuschließen. Ferner können die Erweiterungsmodule auf einfache Weise entfernt oder ausgewechselt werden, ohne dabei die Funktionsfähigkeit der anderen Module zu beeinträchtigen.

## Patentansprüche

1. Anschlußeinrichtung (1) für die Hausleittechnik, mit
einer an eine Busleitung (22) eines Hausleitsystems anschließbaren Anschlußeinheit (3),
einem oder mehreren funktionsspezifischen Erweiterungsmodulen (10₂-10₅), die mit der Anschlußeinheit (3) verbindbar sind und Anschlüsse (12₁-12₆, 13) für den jeweiligen Verbraucher aufweisen, sowie
einer die Busleitung (22) mit den Erweiterungsmodulen (10₂-10₅) verbindenden Busankopplungseinheit,
**dadurch gekennzeichnet,**
**daß** die Anschlußeinheit (3) eine flache längliche Form aufweist, wobei das bzw. die Erweiterungsmodule (10₂-10₅) im montierten Zustand an einer Längsseite (3a) der Anschlußeinheit (3) parallel zu deren Flachseite (3b) angeordnet sind,
wobei die Anschlußeinrichtung ein die Busankopplungseinheit enthaltendes Mastermodul (10₁) aufweist, welches in gleicher Weise wie die Erweiterungsmodule (10₂-10s) mit der Anschlußeinheit (3) verbindbar ist.

2. Anschlußeinrichtung nach Anspruch 1,
**dadurch gekennzeichnet,**
**daß** das bzw. die Erweiterungsmodule (10₂-10₅) lösbar mit der Anschlußeinheit (3) verrastbar sind.

3. Anschlußeinrichtung nach Anspruch 2,
**dadurch gekennzeichnet,**
**daß** das bzw. die Erweiterungsmodule (10₂-10₅) an ihren Rückseiten (15) Rastvorsprünge (17) aufweisen, welche im montierten Zustand in an der Längsseite (3a) der Anschlußeinheit (3) angeordnete Rastöffnungen (8a) eingreifen.

4. Anschlußeinrichtung nach Anspruch 2 oder 3,
**dadurch gekennzeichnet,**
**daß** das bzw. die Erweiterungsmodule (10₂-10₅) ein Betätigungselement (18) zum Lösen der Verrastung mit der Anschlußeinheit (3) aufweisen.

5. Anschlußeinrichtung nach Anspruch 3 und 4,
**dadurch gekennzeichnet,**
**daß** das Betätigungselement ein mit den Rastvorsprüngen (17) zusammenwirkender Griffbügel (18) ist.

6. Anschiußeinrichtung nach einem der vorherigen Ansprüche,
**dadurch gekennzeichnet,**
**daß** die Anschlußeinheit (3) eine ihre Unterseite über die Längsseite (3a) hinaus verlängernde Seitenplatte (2) aufweist, welche eine Auflagefläche für das bzw. die Erweiterungsmodule (10₁-10₅) bildet.

7. Anschlußeinrichtung (1) nach einem der vorherigen Ansprüche,
**dadurch gekennzeichnet,**
**daß** die Anschlußeinheit (3) an ihrer Längsseite mehrere Steckplätze (8₁-8₅) für das bzw. die Erweiterungsmodule (10₂-10₅) aufweist.

8. Anschlußeinrichtung nach Anspruch 9,
**dadurch gekennzeichnet,**
**daß** das bzw. die Erweiterungsmodule (10₁-10₅) an ihren im montierten Zustand der Anschlußeinheit (3) zugewandten Rückseiten (15) Führungsstifte (8₁-8₅) aufweisen.

9. Anschlußeinrichtung nach einem der vorherigen Ansprüche,
**dadurch gekennzeichnet,**
**daß** die Anschlußeinrichtung eine innerhalb der Anschlußein heit (3) verlaufende und mit der Busankopplungseinheit verbundene interne Busleitung (25) aufweist, an die die funktionsspezifischen Erweiterungsmodule (10₂-10₅) anschließbar sind.

10. Anschlußeinrichtung nach einem der Ansprüche 1 bis 8,
**dadurch gekennzeichnet,**
**daß** die Anschlußeinrichtung mehrere innerhalb der Anschlußeinheit (3) verlaufende und mit der Busankopplungseinheit verbundene Datenleitungen (27₂-27₅) aufweist, über welche die funktionsspezifischen Erweiterungsmodule (10₂-10₅) einzeln mit der Busankopplungseinheit verbindbar sind.

## Claims

1. A connecting device (1) for building services management technology, having
a connector unit (3) which can be connected to a bus line (22) of a building services management system, one or more function-specific expansion modules (10₂-10₅), which can be connected to the connector unit (3), and has/have terminals (12₁-12₆, 13) for the respective load, and also
a bus-coupling unit connecting the bus line (22) to the expansion modules (10₂-10₅),
**characterised in that**
the connector unit (3) has a flat, elongate form, wherein the expansion module or modules (10₂-10₅) in the assembled state is/are arranged on a longitudinal side (3a) of the connector unit (3) parallel to its flat side (3b),
wherein the connecting device has a master module (10₁) which contains the bus-coupling unit and can be connected to the connector unit (3) in the same way as the expansion modules (10₂-10₅) .

2. A connecting device according to claim 1,
**characterised in that**
the expansion module or modules (10₂-10₅) is/are detachably latched with the connector unit (3).

3. A connecting device according to claim 2,
**characterised in that**
the expansion module or modules (10₂-10₅) has/have on their rear sides (15) latching projections (17) which in the assembled state engage into latching openings (8a) arranged on the longitudinal side (3a) of the connector unit (3).

4. A connecting device according to claim 2 or 3,
**characterised in that**
the expansion module or modules (10₂-10₅) has/have an actuating element (18) for undoing the latching with the connector unit (3).

5. A connecting device according to claim 3 and 4,
**characterised in that**
the actuating element is a handle (18) that cooperates with the latching projections (17).

6. A connecting device according to one of the previous claims,
**characterised in that**
the connector unit (3) has a side plate (2) that lengthens its lower side beyond the longitudinal side (3a) and forms a supporting surface for the expansion module or modules (10₁-10₅).

7. A connecting device (1) according to one of the previous claims,
**characterised in that**
the connector unit (3) has on its longitudinal side a plurality of plug-in positions (8₁-8₅) for the expansion module or modules (10₂-10₅) .

8. A connecting device according to claim 9,
**characterised in that**
the expansion module or modules (10₁-10₅) has/have guide pins (8₁-8₅) on their rear sides (15) facing the connector unit (3) in the assembled state.

9. A connecting device according to one of the previous claims,
**characterised in that**
the connecting device has an internal bus line (25) which extends within the connector unit (3) and is connected to the bus-coupling unit and to which the function-specific expansion modules (10₂-10₅) can be connected.

10. A connecting device according to one of claims 1 to 8,
**characterised in that**
the connecting device has a plurality of data lines (27₂-27₅) which extend within the connector unit (3) and are connected to the bus-coupling unit and by way of which the function-specific expansion modules (10₂-10₅) can be individually connected to the bus-coupling unit.

## Revendications

1. Dispositif de connexion (1) pour réseaux locaux, comportant
une unité de connexion (3) pouvant être connectée à une ligne de bus (22) d'un système de réseau local,
un ou plusieurs modules d'extension (10₂-10₅) présentant une fonction spécifique, lesquels peuvent être reliés à l'unité de connexion (3) et présentent des connexions (12₁-12₆, 13) pour chaque consommateur, ainsi
qu'une unité d'accouplement de bus reliant la ligne de bus (22) aux modules d'extension (10₂-10₅),
**caractérisé en ce**
**que** l'unité de connexion (3) présente une forme allongée plate, sachant que le ou les modules d'extension (10₂-10₅) sont disposés à l'état monté au niveau d'un côté longitudinal (3a) de l'unité de connexion (3) de manière parallèle par rapport à son côté plat (3b),
sachant que le dispositif de connexion présente un module maître (10₁) contenant l'unité d'accouplement de bus, lequel module maître peut être relié de la même manière que les modules d'extension (10₂-10₅) à l'unité de connexion (3).

2. Dispositif de connexion selon la revendication 1,
**caractérisé en ce**
**que** le ou les modules d'extension (10₂-10₅) peuvent être enclenchés avec l'unité de connexion (3) de manière détachable.

3. Dispositif de connexion selon la revendication 2,
**caractérisé en ce**
**que** le ou les modules d'extension (10₂-10₅) présentent au niveau de leurs côtés arrière (15) des parties d'enclenchement faisant saillie (17), lesquelles viennent en prise à l'état monté avec des orifices d'enclenchement (8a) disposés au niveau du côté longitudinal (3a) de l'unité de connexion (3).

4. Dispositif de connexion selon la revendication 2 ou 3,
**caractérisé en ce**
**que** le ou les modules d'extension (10₂-10₅) présentent un élément d'actionnement (18) servant à défaire l'enclenchement à l'unité de connexion (3).

5. Dispositif de connexion selon la revendication 3 et 4,
**caractérisé en ce**
**que** l'élément d'actionnement est un étrier de préhension (18) coopérant avec les parties d'enclenchement faisant saillie (17).

6. Dispositif de connexion selon l'une quelconque des revendications précédentes,
**caractérisé en ce**
**que** l'unité de connexion (3) présente une plaque latérale (2) prolongeant son côté inférieur au-delà du côté longitudinal (3a), laquelle plaque latérale forme une surface d'appui pour le ou les modules d'extension (10₁-10₅).

7. Dispositif de connexion (1) selon l'une quelconque des revendications précédentes,
**caractérisé en ce**
**que** l'unité de connexion (3) présente au niveau de son côté longitudinal plusieurs emplacements d'enfichage (8₁-8₅) pour le ou les modules d'extension (10₂-10₅).

8. Dispositif de connexion selon la revendication 9,
**caractérisé en ce**
**que** le ou les modules d'extension (10₁-10₅) présentent au niveau de leurs côtés arrière (15) tournés vers l'unité de connexion (3) à l'état monté des tiges de guidage (8₁-8₅).

9. Dispositif de connexion selon l'une quelconque des revendications précédentes,
**caractérisé en ce**
**que** le dispositif de connexion présente une ligne de bus (25) interne s'étendant à l'intérieur de l'unité de connexion (3) et reliée à l'unité d'accouplement de bus, à laquelle ligne de bus peuvent être connectés les modules d'extension (10₂-10₅) présentant une fonction spécifique.

10. Dispositif de connexion selon l'une quelconque des revendications 1 à 8,
**caractérisé en ce**
**que** le dispositif de connexion présente plusieurs lignes de données (27₂-27₅) s'étendant à l'intérieur de l'unité de connexion (3) et reliées à l'unité d'accouplement de bus, par l'intermédiaire desquelles les modules d'extension (10₂-10₅) présentant une fonction spécifique peuvent être reliés individuellement à l'unité d'accouplement de bus.
